# EUROPEAN PATENT APPLICATION

(11) **EP 4 738 005 A2**
(43) Date of publication of application: **06.05.2026**
(21) Application number: 25212229.6
(22) Date of filing: 30.10.2025
(51) Int. Cl.: G03F 1/24, G03F 1/48

(54) **REFLECTIVE MASK BLANK AND METHOD FOR MANUFACTURING REFLECTIVE MASK**

(30) Priority: 30.10.2024 JP 2024190260
(71) Applicant: SHIN-ETSU CHEMICAL CO., LTD., Tokyo 1000005 (JP)
(72) Inventor: INAZUKI, Yukio, Niigata, 942-8601 (JP); KOSAKA, Takuro, Niigata, 942-8601 (JP); OGOSE, Taiga, Niigata, 942-8601 (JP); SAKURAI, Keisuke, Niigata, 942-8601 (JP); MIMURA, Shohei, Niigata, 942-8601 (JP); KANEKO, Hideo, Niigata, 942-8601 (JP)
(74) Representative: Hindles Limited

(57) **Abstract**

A reflective mask blank is a material for a reflective mask used in EUV lithography using EUV light as exposure light. The reflective mask blank comprising: a substrate (1); a multilayer reflective film (2) that reflects the exposure light and is formed above one main surface of the substrate (1); a protective film (3) that protects the multilayer reflective film (2) and is formed above the multilayer reflective film (2); an absorption film (5) that absorbs the exposure light and is formed above the protective film (3); and an etch-stop film (4) that contains niobium (Nb) and is provided between the protective film (3) and the absorption film (5). The protective film (3) has at least one layer containing rhodium (Rh). A layer in contact with the protective film (3) in the multilayer reflective film (2) contains molybdenum (Mo).

## Description

### Technical Field

The present invention relates to a reflective mask blank that is a material for a reflective mask used for manufacturing a semiconductor device such as an LSI, and a method for manufacturing a reflective mask from the reflective mask blank.

### Background Art

In the manufacturing process of semiconductor devices, a photolithography technique for irradiating a transfer mask with exposure light and transferring a circuit pattern formed on the mask onto a semiconductor substrate (semiconductor wafer) via a reduction projection optical system is repeatedly used. In the related art, the wavelength of exposure light is mainly 193 nm, which is argon fluoride (ArF) excimer laser light, and a pattern having smaller dimensions than the exposure wavelength has been finally formed by adopting a process called multi-patterning in which an exposure process and a processing process are combined a plurality of times.

However, it has been necessary to form even finer patterns due to continuous miniaturization of device patterns, and thus an EUV lithography technique using extreme ultraviolet (hereinafter, referred to as "EUV") light having a wavelength shorter than that of ArF excimer laser light as exposure light has been used. EUV light is light having a wavelength of about 0.2 to 100 nm, more specifically, light having a wavelength of around 13.5 nm. Since EUV light has extremely low transparency to substances, transmission type projection optical systems and masks of the related art cannot be used, and thus reflection type optical elements are used. Therefore, a reflective mask is also used as a mask for pattern transfer.

In the reflective mask, a multilayer reflective film that reflects EUV light is formed on a substrate, and a pattern of an absorption film that absorbs EUV light is formed on the multilayer reflective film. Meanwhile, the material before patterning of the absorption film (including the material with a resist film formed thereon) is called a reflective mask blank, and the reflective mask blank is used as a material for the reflective mask. In general, the reflective mask blank has a basic structure including a low thermal expansion substrate, a multilayer reflective film that reflects EUV light and is formed on one of two main surfaces of the substrate, and an absorption film that absorbs EUV light and is formed on the multilayer reflective film.

As the multilayer reflective film, a multilayer reflective film that obtains a necessary reflectivity for EUV light by alternately laminating a molybdenum (Mo) layer and a silicon (Si) layer is usually used. As the absorption film, tantalum (Ta) or the like having a relatively large extinction coefficient for EUV light is used (JP 2002-246299 A).

Furthermore, as a protective film (capping film) for protecting the multilayer reflective film during washing of the reflective mask or the like, a ruthenium (Ru) film or a rhodium (Rh) film as disclosed in JP 2002-122981 A or JP 2005-516182 T is formed on the multilayer reflective film. In addition, as an etching mask for when a pattern is formed on the absorption film, a hard mask film containing chromium (Cr) may be formed on the absorption film. Meanwhile, a conductive film is formed on the other main surface of the substrate. As the conductive film, a metal nitride film is proposed for electrostatic chucking, and examples thereof include films mainly containing chromium (Cr) and tantalum (Ta).

### SUMMARY OF INVENTION

### PROBLEM TO BE SOLVED BY INVENTION

The protective film is required to function to protect the multilayer reflective film. Specific examples of the function include a function of protecting the multilayer reflective film so that the multilayer reflective film is not exposed to an etching gas and a cleaning liquid in pattern processing of the absorption film, and a function of suppressing a decrease in reflectivity as exposure is repeated in exposure using a reflective mask.

In the manufacturing process of a reflective mask using a reflective mask blank as a material, when a pattern is formed on the absorption film by dry etching, some degree of over-etching is usually performed to control a pattern shape. Since the over-etching is performed, the protective film is exposed to etching and damaged. In a case where the absorption film is formed of a material containing tantalum (Ta) and not containing oxygen (O), a gas containing chlorine (Cl) and not containing oxygen (O) is preferably used as an etching gas, and thus the protective film is required to have resistance to the dry etching using a gas containing chlorine (Cl) and not containing oxygen (O).

In addition, in a case where a pattern of a hard mask film formed of a material containing chromium (Cr) is used as an etching mask when a pattern is formed on the absorption film, the pattern of the hard mask film is usually removed by dry etching using a gas containing chlorine (Cl) and oxygen (O) after formation of the pattern of the absorption film. However, in that case, the protective film is also exposed to dry etching using a gas containing chlorine (Cl) and oxygen (O). Therefore, the protective film is also required to have resistance to dry etching using a gas containing chlorine (Cl) and oxygen (O).

In a case where the protective film is damaged due to the dry etching during the manufacturing of the reflective mask, and the film quality and the film thickness thus change, there arises a problem that the function of protecting the multilayer reflective film is lost. Therefore, it has been proposed that, in a protective film containing ruthenium (Ru), an additive element such as niobium (Nb) is added to improve the resistance to dry etching, thereby enhancing the protective function of the protective film for the multilayer reflective film.

However, in a case where a chromium (Cr)-based absorption film is laminated on a ruthenium (Ru)-based protective film that is generally used as a protective film for the multilayer reflective film, ruthenium (Ru) is etched by oxygen plasma in dry etching using a gas containing chlorine (Cl) and oxygen (O) used for dry etching of the chromium (Cr)-based film, and thus the ruthenium (Ru)-based film is also etched. Accordingly, the ruthenium (Ru)-based protective film is damaged, and the protective film becomes thin.

Therefore, in a case where Rh is contained in the protective film instead of Ru, a certain degree of resistance to dry etching using a gas containing oxygen (O) is imparted, but there is a problem that the surface becomes oxidized, reducing the reflectivity, or the protective film becomes thin due to a sputtering phenomenon during dry etching.

The present invention has been made to solve the problems, and an object thereof is to provide a reflective mask blank in which a protective film is less likely to be damaged and it is thus possible to suppress a reduction in thickness of the protective film and oxidation of the protective film, and a method for manufacturing a reflective mask using the reflective mask blank.

The inventors of the present application have conducted intensive studies to solve the problems, and as a result, found that, when a protective film contains rhodium (Rh), an uppermost layer of a multilayer reflective film in contact with the protective film is formed of Mo, and a layer containing niobium (Nb) (etch-stop film) is provided between the protective film and an absorption film, the problems can be solved, and completed the present invention.

### MEANS FOR SOLVING PROBLEM

Therefore, the present invention provides the following reflective mask blank and method for manufacturing a reflective mask.

A reflective mask blank according to the present invention is a material for a reflective mask used in EUV lithography using EUV light as exposure light, the reflective mask blank comprises:
a substrate;
a multilayer reflective film that reflects the exposure light and is formed above one main surface of the substrate;
a protective film that protects the multilayer reflective film and is formed above the multilayer reflective film;
an absorption film that absorbs the exposure light and is formed above the protective film; and
an etch-stop film that contains niobium (Nb) and is provided between the protective film and the absorption film,
wherein the protective film has at least one layer containing rhodium (Rh), and
a layer in contact with the protective film in the multilayer reflective film contains molybdenum (Mo).

In the reflective mask blank according to the present invention,
the protective film may be made of rhodium (Rh).

In the reflective mask blank according to the present invention,
the protective film may be a layer containing rhodium (Rh) and ruthenium (Ru).

In the reflective mask blank according to the present invention,
the protective film may have a layer containing rhodium (Rh) and a layer containing ruthenium (Ru).

In the reflective mask blank according to the present invention,
the etch-stop film may be made of niobium (Nb), or a niobium (Nb) compound containing niobium (Nb) and oxygen (O).

A method for manufacturing a reflective mask according to the present invention is a method to manufacture the reflective mask blank according to the above aspect.

### EFFECT OF INVENTION

According to the present invention, in a case where the uppermost layer of the multilayer reflective film that is below and in contact with the protective film formed of a material containing rhodium (Rh) is formed of Mo, a denser protective film can be formed, and when a layer containing niobium (Nb) is provided between the protective film and the absorption film, the protective film is less likely to be damaged even in a case where dry etching is performed using a gas containing oxygen (O), so that it is possible to provide a reflective mask blank in which it is possible to suppress a reduction in thickness and oxidation of the protective film.

### BRIEF DESCRIPTION OF DRAWINGS

FIG. 1 is a cross-sectional view illustrating an example (first aspect) of a reflective mask blank according to an embodiment of the present invention;
FIG. 2 is a cross-sectional view illustrating another example (second aspect) of the reflective mask blank according to the embodiment of the present invention;
FIG. 3 is a cross-sectional view illustrating an example of a reflective mask according to the embodiment of the present invention; and
FIG. 4 is a cross-sectional view illustrating still another example (third aspect) of the reflective mask blank according to the embodiment of the present invention.

### DETAILED DESCRIPTION

Hereinafter, embodiments of the present invention will be described in greater detail.

A reflective mask blank 100 has a substrate 1, a multilayer reflective film 2 that reflects exposure light and is formed on one main surface (surface) of the substrate 1, a protective film 3 that is formed on the multilayer reflective film 2, and an absorption film 5 that absorbs exposure light and is formed above the protective film 3. In addition, the reflective mask blank 100 has an etch-stop film 4 between the protective film 3 and the absorption film 5.

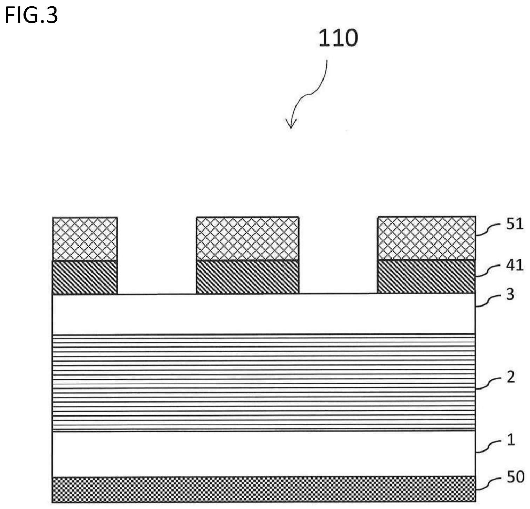

The reflective mask blank 100 is suitable as a material for a reflective mask 110 (see FIG. 3) used in EUV lithography using EUV light as exposure light. The EUV light used in EUV lithography using EUV light as exposure light has a wavelength of 13 to 14 nm, and is usually light having a wavelength of about 13.5 nm. The reflective mask blank 100 and the reflective mask 110 using EUV light as exposure light are also referred to as an EUV mask blank and an EUV mask, respectively.

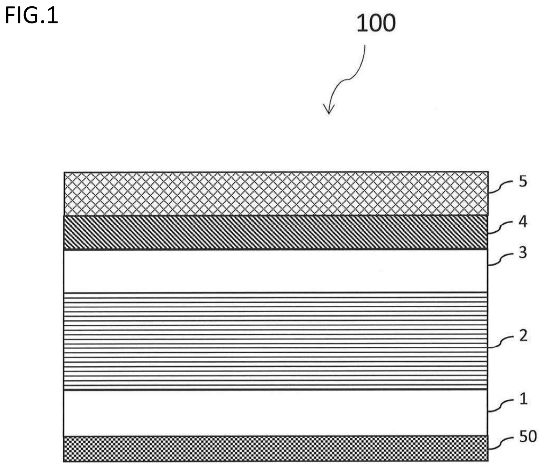

FIG. 1 is a cross-sectional view illustrating an example (first aspect) of the reflective mask blank 100 of the embodiment. The reflective mask blank 100 has a substrate 1, a multilayer reflective film 2 formed on the substrate 1 in contact with the substrate 1, a protective film 3 formed in contact with the multilayer reflective film 2, and an absorption film 5 formed above the protective film 3. In addition, an etch-stop film 4 is provided between the protective film 3 and the absorption film 5.

The substrate 1 preferably has low thermal expansion characteristics for EUV light exposure, and is preferably made of, for example, a material having a thermal expansion coefficient within a range of ±2×10⁻⁸/°C, preferably within a range of ±5×10⁻⁹/°C. Examples of the material include titania-doped quartz glass (SiO₂-TiO₂-based glass). In addition, a substrate having a sufficiently flattened surface is preferably used as the substrate 1, and the surface roughness of the main surface of the substrate 1 is preferably 0.5 nm or less, and more preferably 0.2 nm or less in RMS value. Such surface roughness can be obtained by polishing the substrate 1, for example. Regarding the size of the substrate 1, the substrate 1 preferably has a main surface size of 152 mm square and a thickness of 6.35 mm. The substrate 1 having the above size is a substrate (substrate having a main surface size of 6 inch square and a thickness of 0.25 inches) called a so-called 6025 substrate.

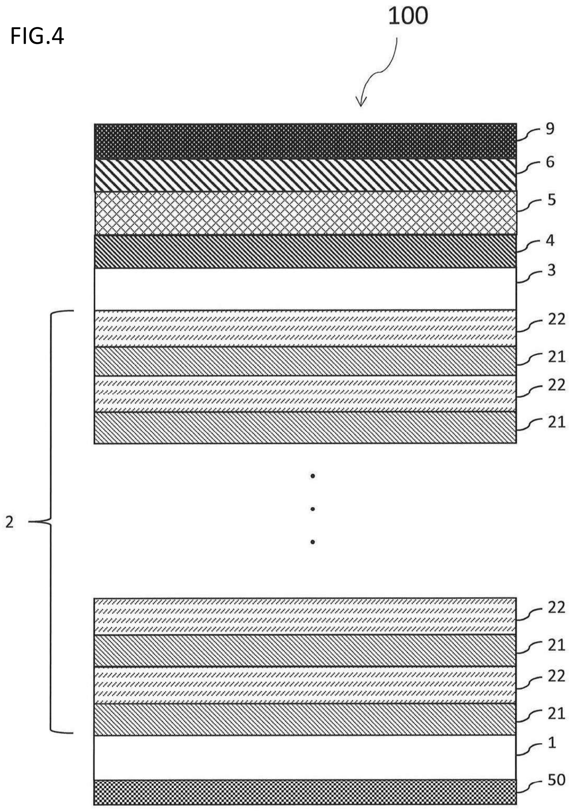

The multilayer reflective film 2 is a film that reflects exposure light in the reflective mask 110 (see FIG. 3). The multilayer reflective film 2 is preferably provided in contact with one main surface of the substrate 1, but another film such as a base film may be provided between the multilayer reflective film 2 and one main surface of the substrate 1. As illustrated in FIG. 4, the multilayer reflective film 2 has a periodically laminated structure in which a high refractive index layer 21 having a relatively high refractive index to exposure light and a low refractive index layer 22 having a relatively low refractive index to exposure light are alternately laminated.

The high refractive index layer 21 is preferably made of a material containing silicon (Si). The high refractive index layer 21 may contain one or more additive elements selected from oxygen (O), nitrogen (N), carbon (C), boron (B), and hydrogen (H), and may be composed of multiple layers including a layer containing an additive element and a layer containing no additive element. The thickness of the high refractive index layer 21 is preferably 3.5 nm or more, and more preferably 4 nm or more, and is preferably 4.9 nm or less, and more preferably 4.4 nm or less.

The low refractive index layer 22 is preferably made of a material containing molybdenum (Mo). The low refractive index layer 22 can also be made of a material containing ruthenium (Ru). A multilayer structure of Mo and Ru may be adopted. The low refractive index layer 22 may contain one or more additive elements selected from oxygen (O), nitrogen (N), carbon (C), boron (B), and hydrogen (H), and may be composed of multiple layers including a layer containing an additive element and a layer containing no additive element. The thickness of the low refractive index layer 22 is preferably 2.1 nm or more, and more preferably 2.6 nm or more, and is preferably 3.5 nm or less, and more preferably 3 nm or less.

The periodically laminated structure may include the high refractive index layer 21 and the low refractive index layer 22, and one or more high refractive index layers 21 and one or more low refractive index layers 22 may be included in one period. The number of layers included in the periodically laminated structure is two or more, and the periodically laminated structure can be composed of, for example, one high refractive index layer 21 and one low refractive index layer 22. In addition, two or more high refractive index layers 21 having different compositions (for example, having different composition ratios, or having different compositions depending on the presence or absence of the additive element) may be included, and two or more low refractive index layers 22 having different compositions (for example, having different composition ratios, or having different compositions depending on the presence or absence of the additive element) may be included. In this case, the number of layers included in the periodically laminated structure is three or more, may be four or more or five or more, and is preferably eight or less. The number of periods is preferably 20 or more, and is preferably 50 or less, and more preferably 40 or less.

The thickness of the multilayer reflective film 2 having the periodically laminated structure is adjusted according to the exposure wavelength and the incidence angle of the exposure light, and is preferably 130 nm or more and 400 nm or less, and more preferably 290 nm or less.

Examples of the method for forming the multilayer reflective film 2 include a sputtering method in which power is supplied to a target and an atmospheric gas is turned into plasma (ionization) by the supplied power to perform sputtering, and an ion beam sputtering method in which a target is irradiated with ion beams. The sputtering method includes a DC sputtering method in which a DC voltage is applied to a target and an RF sputtering method in which a high-frequency voltage is applied to a target. The sputtering method is a film forming method in which, in a state in which a sputtering gas is introduced into a chamber, a voltage is applied to a target, the gas is ionized, and a sputtering phenomenon caused by gas ions is used. In particular, a magnetron sputtering method is advantageous in terms of productivity. The power applied to the target may be either DC or RF, and in a case of DC, pulse sputtering is also included, in which the negative bias applied to the target is reversed for a short period of time to prevent charge-up of the target.

The multilayer reflective film 2 can be formed by, for example, a sputtering method using a sputtering device capable of mounting a plurality of targets. Specifically, a target can be appropriately selected and used from among a molybdenum (Mo) target for forming a layer containing molybdenum (Mo), a ruthenium (Ru) target for forming a layer containing ruthenium (Ru), a silicon (Si) target for forming a layer containing silicon (Si), and the like, and a rare gas such as a helium (He) gas, an argon (Ar) gas, a krypton (Kr) gas, or a xenon (Xe) gas can be used as a sputtering gas to form the multilayer reflective film 2.

In addition, in a case where reactive sputtering using a reactive gas is performed for sputtering, for example, a nitrogen-containing gas such as a nitrogen (N₂) gas when a film containing nitrogen (N) is formed, an oxygen-containing gas such as an oxygen (O₂) gas when a film containing oxygen (O) is formed, a nitrogen oxide gas such as a nitrous oxide (N₂O) gas, a nitrogen monoxide (NO) gas, or a nitrogen dioxide (NO₂) gas when a film containing nitrogen (N) and oxygen (O) is formed, a carbon oxide gas such as a carbon monoxide (CO) gas or a carbon dioxide (CO₂) gas when a film containing carbon (C) and oxygen (O) is formed, a hydrogen-containing gas such as a hydrogen (H₂) gas when a film containing hydrogen (H) is formed, or a hydrocarbon gas such as a methane (CH₄) gas when a film containing carbon (C) and hydrogen (H) is formed, may be used together with a rare gas.

Furthermore, when a layer containing boron (B) is formed, a molybdenum (Mo) target in which boron (B) is added (molybdenum boride (MoB) target), a silicon (Si) target in which boron (B) is added (silicon boride (SiB) target), or the like can be used.

In the present embodiment, the uppermost layer of the multilayer reflective film 2 is a layer containing Mo (for example, Mo layer). The film thickness of the layer containing Mo is preferably as thin as possible, and is preferably 2 nm or less, and more preferably 1 nm or less. The layer in contact with the protective film 3 in the multilayer reflective film 2 contains molybdenum (Mo), which is advantageous in that a denser protective film 3 can be formed.

The protective film 3 is also called a capping film. The protective film 3 is a film for protecting the multilayer reflective film 2. The protective film 3 is usually provided in contact with the multilayer reflective film 2. The protective film 3 is made of a material containing rhodium (Rh).

Examples of the material containing rhodium (Rh) include rhodium (Rh) alone and alloys containing rhodium (Rh) and a metal or metalloid different from rhodium (Rh). Examples of the metal or metalloid different from rhodium (Rh) include ruthenium (Ru), niobium (Nb), rhenium (Re), zirconium (Zr), titanium (Ti), chromium (Cr), and silicon (Si). The material containing rhodium (Rh) is particularly preferably rhodium (Rh) alone, and the protective film 3 is preferably made of rhodium (Rh). The content of the metal or metalloid different from rhodium (Rh) in the protective film 3 is preferably 50 atom% or less, and more preferably 30 atom% or less on average over the entire film. The lower limit of the content of the metal or metalloid different from rhodium (Rh) in the protective film 3 is not particularly limited, but is preferably 5 atom% or more, and more preferably 10 atom% or more. Adding rhodium (Rh) to the protective film 3 is advantageous in that a certain degree of resistance to dry etching using a gas containing oxygen (O) can be realized.

The protective film 3 may have a single layer structure or a multilayer structure in which a plurality of layers having different compositions are combined, and the single layer and the respective layers constituting the plurality of layers may have a gradient composition structure in which the composition continuously changes in the thickness direction. In particular, one or both of the side of the protective film 3 close to the multilayer reflective film 2 (in a case of the multilayer structure, a layer close to the multilayer reflective film 2) and the side of the protective film 3 farthest from the multilayer reflective film 2 (in a case of the multilayer structure, a layer farthest from the multilayer reflective film 2) can be formed of rhodium (Rh).

Specific examples of the dry etching using a gas containing chlorine (Cl) and oxygen (O) include dry etching using a gas including a chlorine (Cl₂) gas and an oxygen (O₂) gas. The gas containing chlorine (Cl) and oxygen (O) may include a rare gas such as a helium (He) gas, an argon (Ar) gas, a krypton (Kr) gas, or a xenon (Xe) gas.

The thickness of the protective film 3 is preferably 1 nm or more, and more preferably 2 nm or more, and is preferably 5 nm or less, and more preferably 4 nm or less.

The protective film 3 can be formed by sputtering using a target appropriately selected from a rhodium (Rh) target, a target of a metal or metalloid different from rhodium (Rh), specifically, a ruthenium (Ru) target, a niobium (Nb) target, a rhenium (Re) target, a zirconium (Zr) target, a titanium (Ti) target, a chromium (Cr) target, and a silicon (Si) target, and a target in which two or more selected from ruthenium (Ru), niobium (Nb), rhenium (Re), zirconium (Zr), titanium (Ti), chromium (Cr), and silicon (Si) are mixed, a target in which rhodium (Rh) is mixed with one or more metals or semimetals other than ruthenium (Ru), selected from niobium (Nb), rhenium (Re), zirconium (Zr), titanium (Ti), chromium (Cr), and silicon (Si), and using a rare gas such as a helium (He) gas, an argon (Ar) gas, a krypton (Kr) gas, or a xenon (Xe) gas as a sputtering gas. For the sputtering, a magnetron sputtering method is preferably used.

The absorption film 5 is a film that absorbs exposure light and reduces a reflectivity in the reflective mask 110. In the reflective mask 110, a transfer pattern is formed by a difference in reflectivity between a part where the absorption film 5 is formed and a part where the absorption film 5 is not formed. The absorption film 5 may be a single layer or include multiple layers, and an antireflection layer or the like may be formed on a surface.

The absorption film 5 preferably contains tantalum (Ta), chromium (Cr), ruthenium (Ru), or platinum (Pt) as a main component. The absorption film 5 is a film of a material that absorbs EUV light and can be patterned, and is preferably formed of a material containing tantalum (Ta), a material containing chromium (Cr), or the like. In the embodiment, the "main component" means a metal element or metalloid element contained at the highest atomic percentage in the film.

The material containing tantalum (Ta) may contain oxygen (O), nitrogen (N), carbon (C), boron (B), and the like. Specific examples of the material containing tantalum (Ta) include Ta alone and tantalum (Ta) compounds such as TaO, TaN, TaON, TaC, TaCO, TaCN, TaCON, TaB, TaOB, TaNB, TaONB, TaCB, TaCOB, TaCNB, and TaCONB. Note that the notation of a compound of a metal or metalloid by its chemical formula indicates the constituent elements of the compound, and does not represent their composition ratio (and the same hereinafter).

In a case where the material containing tantalum (Ta) does not contain oxygen (O), the material can be etched by dry etching using a gas containing chlorine (Cl). In this case, in a case where the material contains nitrogen (N), the etching rate of dry etching using a gas containing chlorine (Cl) increases. In addition, in a case where the material containing tantalum (Ta) contains nitrogen (N) and does not contain oxygen (O), the etching selectivity with respect to the etch-stop film 4 increases in dry etching using a gas containing chlorine (Cl). Therefore, the part of the absorption film 5 containing tantalum (Ta) in contact with the etch-stop film 4 preferably does not contain oxygen (O) and preferably contains a large amount of nitrogen (N).

Specific examples of the dry etching using a gas containing chlorine (Cl) include dry etching using a gas including a chlorine (Cl₂) gas. The gas containing chlorine (Cl) preferably does not include a gas containing oxygen (O). The gas containing chlorine (Cl) may include a rare gas such as a helium (He) gas, an argon (Ar) gas, a krypton (Kr) gas, or a xenon (Xe) gas.

The material containing chromium (Cr) may contain oxygen (O), nitrogen (N), carbon (C), and the like. Specific examples of the material containing chromium (Cr) include Cr alone and chromium (Cr) compounds such as CrO, CrN, CrON, CrC, CrCO, CrCN, and CrCON.

The absorption film 5 (layers constituting the absorption film 5) can be formed by sputtering, and for the sputtering, a magnetron sputtering method is preferably used. Specifically, in the formation using a material containing tantalum (Ta), from a tantalum (Ta) target or a tantalum (Ta) compound target (target containing tantalum (Ta), and oxygen (O), nitrogen (N), carbon (C), boron (B), and the like), and in the formation using a material containing chromium (Cr), from an chromium (Cr) target or an chromium (Cr) compound target (target containing chromium (Cr), and oxygen (O), nitrogen (N), carbon (C), boron (B), and the like), a target is appropriately selected and used according to the composition, and sputtering using a rare gas such as a helium (He) gas, a neon (Ne) gas, an argon (Ar) gas, a krypton (Kr) gas, or a xenon (Xe) gas as a sputtering gas, or reactive sputtering using, together with a rare gas, a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, or a carbon oxide (CO, CO₂) gas can be performed to form the absorption film 5.

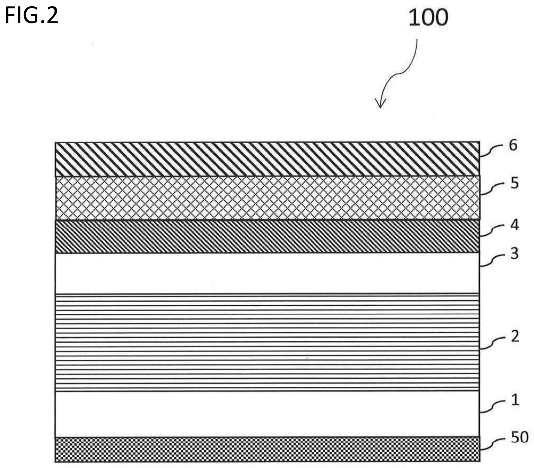

As illustrated in FIG. 2, an etching mask film 6 having etching characteristics different from those of the absorption film 5 can be provided as a hard mask film for the absorption film 5 on the absorption film 5 on the side away from the substrate 1. The etching mask film 6 is a film functioning as a hard mask when the absorption film 5 is dry-etched. The etching mask film 6 is preferably provided in contact with the absorption film 5. The etching mask film 6 may be a single layer or include multiple layers.

FIG. 2 is a cross-sectional view illustrating an example (second aspect) of the reflective mask blank 100 of the embodiment. The reflective mask blank 100 includes a substrate 1, a multilayer reflective film 2 formed on the substrate 1 in contact with the substrate 1, a protective film 3 formed in contact with the multilayer reflective film 2, an etch-stop film 4 formed in contact with the protective film 3, an absorption film 5 formed in contact with the etch-stop film 4, and an etching mask film 6 formed in contact with the absorption film 5.

In a case where the absorption film 5 contains tantalum (Ta), the etching mask film 6 preferably contains chromium (Cr), and is preferably formed of a material containing chromium (Cr). The material containing chromium (Cr) has different etching characteristics from the absorption film 5 when the absorption film 5 formed of a material containing tantalum (Ta) is processed, and thus an etching mask film 6 that is formed of a material containing chromium (Cr) and functions as an etching mask when the absorption film 5 is dry-etched is suitable. Therefore, the material containing chromium (Cr) of the etching mask film 6 preferably does not contain tantalum (Ta). Examples of the material containing chromium (Cr) include Cr alone, CrO, CrN, CrON, CrC, CrOC, CrNC, and CrONC.

In a case where the absorption film 5 contains chromium (Cr), the etching mask film 6 preferably contains tantalum (Ta), and is preferably formed of a material containing tantalum (Ta). The material containing tantalum (Ta) has different etching characteristics from the absorption film 5 when the absorption film 5 formed of a material containing chromium (Cr) is processed, and thus an etching mask film 6 that is formed of a material containing tantalum (Ta) and functions as an etching mask when the absorption film 5 is dry-etched is suitable. Therefore, the material containing tantalum (Ta) of the etching mask film 6 preferably does not contain chromium (Cr). Examples of the material containing tantalum (Ta) include Ta alone, TaO, TaN, TaON, TaC, TaOC, TaNC, and TaONC. The material containing tantalum (Ta) may further contain boron (B) and hydrogen (H).

After the pattern of the absorption film 5 is formed, the etching mask film 6 may be left on the reflective mask 110 as a reflectivity reducing layer for reducing the reflectivity at a wavelength of the light used in inspection such as pattern inspection, or may be removed so as not to remain on the reflective mask 110.

The thickness of the etching mask film 6 is not particularly limited. However, in a case where the thickness is too small, there is a concern that the etching mask film 6 may not function as a hard mask. In a case where the thickness is too large, there is a concern that processing characteristics are deteriorated. Therefore, the thickness is preferably 1 nm or more, more preferably 2 nm or more, and still more preferably 5 nm or more, and is preferably 20 nm or less, and more preferably 10 nm or less.

The etching mask film 6 can be formed by sputtering. Specifically, in the formation using a material containing chromium (Cr), from a chromium (Cr) target or a chromium (Cr) compound target (target containing chromium (Cr), and oxygen (O), nitrogen (N), carbon (C), and the like), and in the formation using a material containing tantalum (Ta), from a tantalum (Ta) target or a tantalum (Ta) compound target (target containing tantalum (Ta), and oxygen (O), nitrogen (N), carbon (C), boron (B), and the like), a target is appropriately selected and used according to the composition, and sputtering using a rare gas such as a helium (He) gas, an argon (Ar) gas, a krypton (Kr) gas, or a xenon (Xe) gas as a sputtering gas, or reactive sputtering using, together with a rare gas, a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, a carbon oxide (CO, CO₂) gas, a hydrogen (H₂) gas, or a hydrocarbon gas (for example, methane (CH₄) gas) can be performed to form the etching mask film 6. For the sputtering, a magnetron sputtering method is preferably used.

The etch-stop film 4 is a film that protects the protective film 3 and prevents etching on the protective film 3 in dry etching using a gas containing chlorine (Cl) and oxygen (O). Therefore, the etch-stop film 4 functions as an etching stopper against dry etching using a gas containing chlorine (Cl) and oxygen (O). The etch-stop film 4 is a film containing niobium (Nb).

The film containing niobium (Nb) has resistance to dry etching using a gas containing chlorine (Cl) and oxygen (O) used for etching of a chromium (Cr)-based film, and functions as a film that protects the protective film 3. Therefore, the etch-stop film 4 containing niobium (Nb) can prevent damage to the protective film 3 when the absorption film 5 containing chromium (Cr) is patterned by dry etching using a gas containing chlorine (Cl) and oxygen (O), or when the absorption film 5 containing tantalum (Ta) is patterned using the pattern of the etching mask film 6 containing chromium (Cr), and then the etching mask film 6 containing chromium (Cr) is removed by dry etching using a gas containing chlorine (Cl) and oxygen (O).

The etch-stop film 4 is preferably made of niobium (Nb) alone, but a niobium (Nb) compound containing niobium (Nb) and oxygen (O), and may be made of, for example, a niobium oxide (NbO). The niobium (Nb) compound containing oxygen (O) preferably contains niobium (Nb) and oxygen (O) as main components, and a total content of niobium (Nb) and oxygen (O) is preferably 70 atom% or more, more preferably 80 atom% or more, still more preferably 91 atom% or more, and particularly preferably 100 atom% on average over the entire film. In addition, the content of niobium (Nb) is preferably 20 atom% or more, more preferably 28 atom% or more, and still more preferably 29 atom% or more on average in the entire film.

The niobium (Nb) compound containing oxygen (O) may further contain an element or a compound that is etched by dry etching using a gas containing chlorine (Cl) or a gas containing fluorine (F). For example, the niobium (Nb) compound containing oxygen (O) may contain elements such as silicon (Si), nitrogen (N), and carbon (C), and compounds thereof. The total content of elements other than niobium (Nb) and oxygen (O) is preferably 30 atom% or less, and more preferably 20 atom% or less on average over the entire film. In this case, the total content of oxygen (O), nitrogen (N) and carbon (C) is preferably 72 atom% or less on average over the entire film.

The etch-stop film 4 may be a single layer or include a plurality of layers. Examples of the plurality of layers include combinations of niobium (Nb)-containing layers having different compositions or composition ratios, such as a combination of a layer made of a niobium (Nb) compound containing oxygen (O) and a layer made of niobium (Nb), and a combination of niobium (Nb) compound layers containing oxygen (O) having different composition ratios. In addition, each layer may be a simple composition layer or a gradient composition layer having a gradient composition. In a case where the etch-stop film 4 contains oxygen (O), it is preferable that the oxygen (O) concentration on the front surface side (side separated from the substrate 1) is increased, or a layer made of a niobium (Nb) compound containing oxygen (O) is provided on the front surface side and a layer made of niobium (Nb) or a layer containing niobium (Nb) and containing no oxygen (O) is provided on the substrate 1 side (rear surface side).

In the embodiment, specific examples of the dry etching using a gas containing fluorine (F) include dry etching using a gas including a carbon tetrafluoride (CF₄) gas or a sulfur hexafluoride (SF₆) gas. The gas containing fluorine (F) may include a rare gas such as a helium (He) gas, an argon (Ar) gas, a krypton (Kr) gas, or a xenon (Xe) gas.

The thickness of the etch-stop film 4 is preferably 0.5 nm or more, and more preferably 1 nm or more, and is preferably 10 nm or less, and more preferably 5 nm or less.

The etch-stop film 4 can be formed by sputtering. The etch-stop film 4 can be formed by sputtering using, as a target, a niobium (Nb) target, and if necessary, a metal or metalloid target different from niobium (Nb), specifically, a silicon (Si) target or the like, and using, as a sputtering gas, a rare gas such as a helium (He) gas, an argon (Ar) gas, a krypton (Kr) gas, or a xenon (Xe) gas, or reactive sputtering using a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, or a carbon oxide (CO, CO₂) gas together with the rare gas. For the sputtering, a magnetron sputtering method is preferably used.

In a case where the etch-stop film 4 contains oxygen (O), niobium (Nb) is easily oxidized naturally, and thus a film of niobium (Nb) alone is formed and oxidized by being exposed to an atmosphere containing oxygen (O) such as the air, whereby a niobium (Nb) compound containing oxygen (O) can be obtained. In a case where the film of niobium (Nb) alone is oxidized, the film may be heat-treated.

A conductive film 50 used for electrostatically chucking the reflective mask 110 to an exposure device (for example, EUV scanner) may be provided on the other main surface (rear surface), which is a surface opposite to one main surface of the substrate 1, preferably in contact with the other main surface.

The conductive film 50 preferably has a sheet resistance of 100 Ω/□ or less, and its material is not particularly limited. Examples of the material of the conductive film 50 include a material containing tantalum (Ta) or chromium (Cr). In addition, the material containing tantalum (Ta) may contain oxygen (O), nitrogen (N), carbon (C), boron (B), and the like, and the material containing chromium (Cr) may contain oxygen (O), nitrogen (N), carbon (C), and the like. Examples of the material containing tantalum (Ta) include Ta alone and tantalum (Ta) compounds such as TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) include Cr alone and chromium (Cr) compounds such as CrO, CrN, CrON, CrC, CrCN, CrCO, and CrCON.

The thickness of the conductive film 50 is not particularly limited as long as the conductive film 50 functions for electrostatic chucking, but is usually about 20 to 300 nm. The thickness of the conductive film 50 is preferably set so that the film stress is balanced with the films and the film patterns formed on one main surface (surface) side after formation of the reflective mask 110, that is, after formation of the pattern of the absorption film 5. The conductive film 50 may be formed before the multilayer reflective film 2 is formed, or may be formed after all the films of the substrate 1 on the multilayer reflective film 2 side are formed. In addition, the conductive film 50 may be formed after some of the films of the substrate 1 on the multilayer reflective film 2 side are formed, and then the remaining films of the substrate 1 on the multilayer reflective film 2 side may be formed. The conductive film 50 can be formed by, for example, a magnetron sputtering method.

As illustrated in FIG. 4, the reflective mask blank 100 of the embodiment may have a resist film 9 formed on the side farthest from the substrate 1. The resist film 9 is preferably an electron beam (EB) resist.

From the reflective mask blank 100, for example, a reflective mask 110 having a substrate 1, a multilayer reflective film 2 formed on one main surface of the substrate 1, a protective film 3 formed in contact with the multilayer reflective film 2, a pattern of an etch-stop film 4 formed in contact with the protective film 3, and a pattern (absorption film pattern) 51 of an absorption film 5 formed in contact with the pattern of the etch-stop film 4 can be manufactured. In the reflective mask 110, a transfer pattern is formed by a difference in reflectivity between a part where the absorption film 5 is formed and a part where the absorption film 5 is not formed.

FIG. 3 is a cross-sectional view illustrating an example of the reflective mask 110 of the embodiment. The reflective mask 110 includes a substrate 1, a multilayer reflective film 2 formed on the substrate 1 in contact with the substrate 1, a protective film 3 formed in contact with the multilayer reflective film 2, a pattern 41 of an etch-stop film 4 formed in contact with the protective film 3, and a pattern 51 of an absorption film 5 formed in contact with the pattern 41 of the etch-stop film 4. In the reflective mask 110, the pattern 51 of the absorption film 5 is formed above the protective film 3 via the pattern 41 of the etch-stop film 4.

The reflective mask 110 of the embodiment can be manufactured by a method including a step of preparing the reflective mask blank 100, a step of forming a resist film 9 on the absorption film 5 if necessary, a step of forming a resist pattern from the resist film 9 on the absorption film 5, a step of forming a pattern of the absorption film 5 by etching the absorption film 5 with the resist pattern as an etching mask, a step of removing the resist pattern, and a step of removing the etch-stop film 4 in a part exposed by removing the absorption film 5.

The absorption film 5 formed of a material containing chromium (Cr) can be etched by dry etching using a gas containing chlorine (Cl) and oxygen (O).

In this case, since the etch-stop film 4 containing niobium (Nb) is not etched by dry etching using a gas containing chlorine (Cl) and oxygen (O), damage to the protective film 3 can be further prevented.

The absorption film 5 formed of a material containing tantalum (Ta) can be etched by dry etching using a gas containing chlorine (Cl) or a gas containing fluorine (F).

In the dry etching of the absorption film 5 containing tantalum (Ta), dry etching using a fluorine (F)-containing gas is preferable when a part containing oxygen (O) formed by natural oxidation or the like is etched, and dry etching using a chlorine (Cl)-containing gas is preferable when a part containing no oxygen (O) is etched. Therefore, the absorption film 5 containing tantalum (Ta) is preferably patterned by initially performing dry etching using a fluorine (F)-containing gas and then switching midway to dry etching using a chlorine (Cl)-containing gas. In this case, since the etch-stop film 4 has low resistance to dry etching using a chlorine (Cl)-containing gas, the etching is preferably performed so that the etch-stop film 4 remains. In order to perform the etching so that the etch-stop film 4 remains, for example, an end point detector or the like attached to an etching device can be used.

In addition, the reflective mask 110 can be manufactured by a method including a step of preparing the reflective mask blank 100, a step of forming a resist film 9 on the etching mask film 6 if necessary, a step of forming a resist pattern from the resist film 9 on the etching mask film 6, a step of forming a pattern of the etching mask film 6 by etching the etching mask film 6 with the resist pattern as an etching mask, a step of forming a pattern of the absorption film 5 by etching the absorption film 5 with the pattern of the etching mask film 6 as an etching mask, a step of removing the resist pattern, a step of removing the pattern of the etching mask film 6, and a step of removing the etch-stop film 4 in a part exposed by removing the absorption film 5.

After the pattern of the absorption film 5 is formed, in a case where the etching mask film 6 is formed of a material containing tantalum (Ta), the pattern of the etching mask film 6 can be removed by dry etching using a gas containing chlorine (Cl) or a gas containing fluorine (F), and in a case where the etching mask film 6 is formed of a material containing chromium (Cr), the pattern of the etching mask film 6 can be removed by dry etching using a gas containing chlorine (Cl) and oxygen (O).

In a case where the absorption film 5 contains tantalum (Ta), a film containing chromium (Cr) is provided as the etching mask film 6, the etching mask film 6 is patterned by dry etching using a gas containing chlorine (Cl) and oxygen (O) to form a pattern of the etching mask film 6, the absorption film 5 is patterned with the pattern of the etching mask film 6 as an etching mask, and then the etching mask film 6 can be removed by dry etching using a gas containing chlorine (Cl) and oxygen (O).

In this case, since the etch-stop film 4 containing niobium (Nb) is not etched by dry etching using a gas containing chlorine (Cl) and oxygen (O), damage to the protective film 3 can be prevented.

The resist pattern and the etch-stop film 4 in a part exposed by removing the absorption film 5 can be removed by a sulfuric acid/hydrogen peroxide mixture (SPM).

In addition, the etch-stop film 4 in a part exposed by removing the absorption film 5 can be removed by dry etching using a gas containing chlorine (Cl) or a gas containing fluorine (F), but is preferably removed by a sulfuric acid/hydrogen peroxide mixture (SPM). In that case, the etch-stop film 4 can be removed simultaneously with the removal of the resist pattern.

The pattern of the absorption film 5 and the exposed protective film 3 can be subjected to a treatment in which the pattern of the absorption film 5 and the exposed protective film 3 are brought into contact with a sulfuric acid/hydrogen peroxide mixture (SPM), such as cleaning using a sulfuric acid/hydrogen peroxide mixture (SPM).

### Examples

Hereinafter, the present invention will be described in detail with reference to Examples and Comparative Examples, but is not limited to the following Examples.

### [Example 1]

On one main surface of a precision-polished substrate 1 having a low thermal expansion coefficient and formed of titania-doped SiO₂, a multilayer reflective film 2 in which a molybdenum (Mo) layer and a silicon (Si) layer were alternately laminated by 40 pairs (periods), with one pair (period) consisting of a molybdenum (Mo) layer having a thickness of 3 nm and a silicon (Si) layer having a thickness of 4 nm, was formed by sputtering. In that case, an uppermost layer of the multilayer reflective film 2 was made of 1 nm-thick Mo. Next, a ruthenium (Ru) film having a thickness of 1.2 nm was formed as a protective film 3 on the multilayer reflective film 2, and then a rhodium (Rh) film having a thickness of 2 nm was formed by sputtering. The multilayer reflective film 2 and the protective film 3 have a reflectivity of 64% when EUV light having a wavelength of 13.5 nm is made incident at an incidence angle of 6°.

Next, a niobium oxide (NbO) film (Nb:O=2:5 (atomic ratio)) having a thickness of 2 nm was formed as an etch-stop film 4 on the protective film 3. The niobium oxide (NbO) film was formed by first forming a niobium (Nb) film by sputtering while applying a power of 750 W to a niobium (Nb) target and flowing an argon (Ar) gas at a flow rate of 12 sccm, and then oxidizing the niobium (Nb) film through a heat treatment at 150°C for 10 minutes in the air.

Next, a chromium nitride (CrN) film (Cr:N=4:1 (atomic ratio)) having a thickness of 45 nm was formed as an absorption film 5 on the etch-stop film 4. The chromium nitride (CrN) film was formed by sputtering while applying a power of 1000 W to a chromium (Cr) target and flowing an argon (Ar) gas at a flow rate of 20 sccm and a nitrogen (N₂) gas at 10 sccm.

In addition, as a conductive film 50, a tantalum nitride (TaN) film having a thickness of 70 nm was formed on the other main surface of the substrate 1 by sputtering to obtain a reflective mask blank 100.

A reflective mask 110 was manufactured from the obtained reflective mask blank 100. First, an electron beam (EB) resist was applied onto the absorption film 5 to form a resist film 9. A pattern was written on the resist film 9 by electron beams (EB), followed by development, to form a resist pattern having a line-and-space (L/S) pattern with a line width of 200 nm.

Next, with the resist pattern as an etching mask, the absorption film 5 was patterned by dry etching using a gas including a chlorine (Cl₂) gas and an oxygen (O₂) gas, to form a pattern of the absorption film 5. The dry etching was performed through an inductively coupled plasma (ICP) method under the conditions of Cl₂ flow rate: 185 sccm, O₂ flow rate: 55 sccm, He flow rate: 9.25 sccm, pressure: 6 mTorr (0.8 Pa), ICP power: 400 W, RIE voltage: 700 V, and over-etching: 454 seconds. At this stage, when a cross section of the part where the absorption film 5 was etched was observed by a transmission electron microscope (TEM), the etch-stop film 4 remained with a thickness of 2 nm in all cases.

Next, by a sulfuric acid/hydrogen peroxide mixture (SPM), the resist pattern was removed and the etch-stop film 4 in a part exposed by removing the absorption film 5 was removed also, thereby obtaining the reflective mask 110. When a cross section of the part where the absorption film 5 was etched was observed by a transmission electron microscope (TEM), the etch-stop film 4 was removed, but the protective film 3 remained without being damaged in the same form as when it was formed. In addition, good patterns of the absorption film 5 and the etch-stop film 4 were obtained.

### [Example 2]

After a multilayer reflective film 2 was formed in the same manner as in Example 1, a rhodium (Rh) film was formed in a thickness of 3 nm as a protective film 3, and an etch-stop film 4, an absorption film 5, and a conductive film 50 on the other main surface of the substrate 1 were formed in the same manner as in Example 1, thereby obtaining a reflective mask blank 100. Next, a resist pattern was formed in the same manner as in Example 1. Next, in the same manner as in Example 1, the absorption film 5 was patterned by dry etching using a gas including a chlorine (Cl₂) gas and an oxygen (O₂) gas with the resist pattern as an etching mask, to form a pattern of the absorption film 5.

Next, by a sulfuric acid/hydrogen peroxide mixture (SPM), the resist pattern was removed and the etch-stop film 4 in a part exposed by removing the absorption film 5 was removed also, thereby obtaining the reflective mask 110. When a cross section of the part where the absorption film 5 was etched was observed by a transmission electron microscope (TEM), the etch-stop film 4 was removed, but the protective film 3 remained without being damaged in the same form as when it was formed. In addition, good patterns of the absorption film 5 and the etch-stop film 4 were obtained.

### [Comparative Example 1]

A reflective mask blank 100 was obtained in the same manner as in Example 1, except that a niobium oxide (NbO) film as the etch-stop film 4 was not formed. Next, a resist pattern was formed in the same manner as in Example 1. Next, in the same manner as in Example 1, the absorption film 5 was patterned by dry etching using a gas including a chlorine (Cl₂) gas and an oxygen (O₂) gas with the resist pattern as an etching mask, to form a pattern of the absorption film 5. When a cross section of the part where the absorption film 5 was etched was observed by a transmission electron microscope (TEM), the protective film 3 became thin, and its surface was oxidized.

### Reference Signs List

- 1: Substrate
- 2: Multilayer reflective film
- 3: Protective film
- 4: Etch-stop film
- 5: Absorption film
- 6: Etching mask film
- 41: Pattern of etch-stop film
- 51: Pattern of absorption film
- 100: Reflective mask blank
- 110: Reflective mask

## Claims

1. A reflective mask blank that is a material for a reflective mask used in EUV lithography using EUV light as exposure light, the reflective mask blank comprising:
a substrate (1);
a multilayer reflective film (2) that reflects the exposure light and is formed above one main surface of the substrate (1);
a protective film (3) that protects the multilayer reflective film (2) and is formed above the multilayer reflective film (2);
an absorption film (5) that absorbs the exposure light and is formed above the protective film (3); and
an etch-stop film (4) that contains niobium (Nb) and is provided between the protective film (3) and the absorption film (5),
wherein the protective film (3) has at least one layer containing rhodium (Rh), and
a layer in contact with the protective film (3) in the multilayer reflective film (2) contains molybdenum (Mo).

2. The reflective mask blank according to claim 1,
wherein the protective film (3) is made of rhodium (Rh).

3. The reflective mask blank according to claim 1,
wherein the protective film (3) is a layer containing rhodium (Rh) and ruthenium (Ru).

4. The reflective mask blank according to claim 1,
wherein the protective film (3) has a layer containing rhodium (Rh) and a layer containing ruthenium (Ru).

5. The reflective mask blank according to any one of claims 1 to 4,
wherein the etch-stop film (4) is made of niobium (Nb), or a niobium (Nb) compound containing niobium (Nb) and oxygen (O).

6. A method for manufacturing a reflective mask from the reflective mask blank according to any one of claims 1 to 5.
